# EUROPÄISCHE PATENTSCHRIFT

(11) **EP 2 526 574 B1**
(45) Veröffentlichungstag und Bekanntmachung des Hinweises auf die Patenterteilung: **20.01.2016**
(21) Anmeldenummer: 11701088.4
(22) Anmeldetag: 21.01.2011
(51) Int. Cl.: H01L 41/273, H01L 41/297, H01L 41/083, H01L 41/047

(54) **VERFAHREN ZUR HERSTELLUNG EINES PIEZOELEKTRISCHEN VIELSCHICHTBAUELEMENTS**
METHOD FOR PRODUCING A PIEZOELECTRIC MULTILAYER COMPONENT
PROCÉDÉ DE FABRICATION D'UN ÉLÉMENT MULTICOUCHE PIÉZOÉLECTRIQUE

(30) Priorität: 22.01.2010 DE 102010005403
(43) Veröffentlichungstag der Anmeldung: 28.11.2012
(73) Patentinhaber: Epcos AG, 81669 München (DE)
(72) Erfinder: GLAZUNOV, Alexander, 8530 Deutschlandsberg (AT); DERNOVSEK, Oliver, 8501 Lieboch (AT)
(74) Vertreter: Epping - Hermann - Fischer
(86) Internationale Anmeldenummer: PCT/EP2011/050847
(87) Internationale Veröffentlichungsnummer: WO 2011/089230

(56) Entgegenhaltungen:
- WO-A1-2006/000479
- WO-A1-2006/103154
- DE-T2- 68 912 365
- JP-A- 2007 180 387

## Beschreibung

Es wird ein Verfahren zur Herstellung eines piezoelektrischen Vielschichtbauelements angegeben, bei dem ein Stapel aus piezoelektrischen Grünfolien und Schichten aus Elektrodenmaterial gebildet und gesintert wird.

Weiterhin wird ein piezoelektrisches Vielschichtbauelement mit einem Stapel aus gesinterten piezoelektrischen Schichten und dazwischen angeordneten Innenelektroden angegeben. Ein derartiges Vielschichtbauelement ist beispielsweise ein Piezoaktor, der zum Betätigen eines Einspritzventils in einem Kraftfahrzeug eingesetzt werden kann.

Die Zuverlässigkeit von piezoelektrischen Vielschichtbauelementen hängt von der Beherrschung von möglicherweise bei ihrer Herstellung auftretenden Rissen ab. Solche Risse können beispielsweise während thermischen Prozessen, wie Sintern, Metallisieren und Löten oder bei der Polarisation auftreten, da aufgrund von unterschiedlichen Dehnungen in verschiedenen Bereichen des Bauelements elastische Spannungen entstehen. Solche so genannten Entlastungsrisse oder Polungsrisse können weiterhin abknicken, senkrecht zu den Elektroden verlaufen und damit beispielsweise zwei Elektroden überbrücken, was zu einem Kurzschluss und zu einem Versagen des Bauelements führt.

JP 2007-180387 A offenbart ein Verfahren zur Herstellung eines piezoelektrischen Vielschichtbauelements umfassend die Schritte: A) Bereitstellen von piezoelektrischen Grünfolien enthaltend ein piezoelektrisches Material (PZT), B) Bereitstellen eines Elektrodenmaterials enthaltend Pd (AgPd), C) Abwechselndes Anordnen von Grünfolien und Schichten aus Elektrodenmaterial zur Bildung eines Stapels und D) Sintern des Stapels, wobei im Verfahrensschritt B) dem Elektrodenmaterial PbO beigemischt wird.

DE 68912365 T2 offenbart einen Mehrschichtkondensator aus abwechselnden Schichten aus einem dielektrischen oxidischen keramischen Material und einem Elektrodenmaterial mit Palladium, wobei die Schichten aus Elektrodenmaterial aus einer Paste hergestellt werden, die Palladium, ein einstweiliges Bindemittel und Blei in Form von Bleioxid oder metallischem Blei umfasst, wobei diese Paste gebrannt wird um das einstweilige Bindemittel unter Bildung von Elektroden aus einer festen Lösung von metallischem Blei im Palladium zu entfernen.

WO 2006/000479 A1 lehrt ein piezoelektrisches Vielschichtbauelement aufweisend einen Stapel aus gesinterten piezoelektrischen Schichten und dazwischen angeordneten Innenelektroden, wobei auf der Oberfläche zumindest einer Innenelektrode ein Bereich vorhanden ist, der eine Sollbruchstelle aufweist.

WO 2006/103154 A1 offenbart einen monolithisch gesinterten Piezostapelaktor mit Rissen an der Sollbruch-Grenzfläche von Innenelektroden und Piezokeramik.

Es ist eine zu lösende Aufgabe, ein Verfahren zur Herstellung eines piezoelektrischen Vielschichtbauelements anzugeben, das eine erhöhte Zuverlässigkeit aufweist. Diese Aufgabe wird durch ein Verfahren gemäß dem Patentanspruch 1 gelöst. Weitere Ausführungsformen des Verfahrens sind Gegenstand weiterer Patentansprüche.

Es wird ein Verfahren zur Herstellung eines piezoelektrischen Vielschichtbauelements bereitgestellt, das die die Schritte umfasst:
A) Bereitstellen von piezoelektrischen Grünfolien enthaltend ein piezoelektrisches Material,
B) Bereitstellen eines Elektrodenmaterials enthaltend Pd,
C) Abwechselndes Anordnen von Grünfolien und Schichten aus Elektrodenmaterial zur Bildung eines Stapels,
D) Sintern des Stapels.

Dabei wird im Verfahrensschritt C) zumindest eine Schicht aus Elektrodenmaterial mit einer Beschichtung, die PbO enthält, versehen und/oder im Verfahrensschritt B) dem Elektrodenmaterial PbO beigemischt.

Mit diesem Verfahren wird ein piezoelektrisches Vielschichtbauelement hergestellt, das piezoelektrische Keramikschichten mit dazwischen angeordneten Innenelektroden aufweist.

Die piezoelektrischen Grünfolien können ein Material aufweisen, das zu Blei-Zirkon-Titanat (PZT) Keramik gesintert werden kann.

"Abwechselndes Anordnen" kann auch bedeuten, dass nicht auf jeder Grünfolie eine Schicht aus Elektrodenmaterial aufgebracht wird. Beispielsweise können einige piezoelektrische Grünfolien übereinander angeordnet sein, zwischen denen sich keine Schichten aus Elektrodenmaterial befinden.

Die Schichten aus Elektrodenmaterial bilden im fertigen Vielschichtbauelement die Innenelektroden und können mittels eines Siebdruckverfahrens als Metallpaste auf die Grünfolien aufgebracht werden.

Das Elektrodenmaterial, das Pd enthält und eine Metallpaste sein kann, kann eine Mischung oder eine Legierung von Ag und Pd oder von Cu und Pd aufweisen. Weitere, Pd-haltige Mischungen und Legierungen sind ebenso denkbar. Weiterhin kann das Elektrodenmaterial auch eine Pd-haltige Metallpaste, in die PbO gleichmäßig verteilt zugegeben ist, sein.

Weiterhin kann die im Verfahrensschritt C) auf die Schicht aus Elektrodenmaterial aufgebrachte PbO enthaltende Beschichtung mittels Siebdruck auf das Elektrodenmaterial aufgebracht werden.

Der im Verfahrensschritt C) gebildete Stapel wird anschließend verpresst und dann die Grünfolien und die Schichten aus Elektrodenmaterial im Verfahrensschritt D) gemeinsam gesintert, so dass ein Vielschichtbauelement aus piezoelektrischen Schichten mit dazwischen angeordneten Innenelektroden entsteht.

Der Verfahrensschritt D) umfasst weiterhin die Teilschritte
D1) Sintern bei einer Temperatur von bis zu 400°C,
D2) Sintern bei einer Temperatur, die in einem Bereich von 400°C bis 700°C liegt,
D3) Sintern bei einer Temperatur von über 700°C, wobei sich im Teilschritt D2) zwischen dem Elektrodenmaterial und dem piezoelektrischen Material eine Zwischenphase enthaltend PbPdO₂ bildet.

Die Temperatur im Teilschritt D3) kann beispielsweise bis zu 1200°C betragen. Während der Sinterung finden Reaktionen zwischen dem PbO, das in der Beschichtung und/oder in dem Elektrodenmaterial enthalten ist, und dem Pd, das in dem Elektrodenmaterial enthalten ist, statt, wobei das PbPdO₂ gebildet wird. Die PbPdO₂ enthaltende Zwischenphase kann also beispielsweise dort gebildet werden, wo die Beschichtung aus PbO auf dem Elektrodenmaterial aufgebracht worden ist. Es kann also eine Zwischenphase aus PbPdO₂ gebildet werden, die zwischen dem piezoelektrischen Material und dem Elektrodenmaterial vorhanden ist, während sich die Beschichtung, die PbO enthält, weitgehend zersetzt. Die Zwischenphase kann beispielsweise eine Dicke von weniger als 1 µm aufweisen.

Die Reaktionen, die im Verfahrensschritt D) ablaufen, können folgendermaßen beschrieben werden:
Im Teilschritt D1) wird durch die Sinteratmosphäre PdO gebildet, wobei das Pd aus dem Elektrodenmaterial heraus diffundiert:

   Pd + ½ O₂ → PdO

Im darauf folgenden Teilschritt D2) wird aus dem PdO zusammen mit dem in der Beschichtung und/oder im Elektrodenmaterial vorhandenen PbO die Zwischenphase aus PbPdO₂ gebildet. Dabei zersetzt sich die Beschichtung weitgehend:

PdO + PbO → PbPdO₂

Schließlich kann sich im Teilschritt D3) das PbPdO₂ zumindest teilweise in Pd und PbO zersetzen:

PbPdO₂ → PbO + Pd + ½ O₂

Dabei kann das metallische Pd wieder zurück in das Elektrodenmaterial zurückdiffundieren. Das freie PbO kann zumindest teilweise in die Atmosphäre entweichen oder in dem piezoelektrischen Material oder Elektrodenmaterial verbleiben

Das im Teilschritt D2) gebildete PbPdO₂ kann ein größeres Volumen aufweisen als PbO und als das piezoelektrische Material. Durch die auftretende Volumenänderung zwischen den Teilschritten kann eine Spannungserhöhung in dem Bereich zwischen dem Elektrodenmaterial und dem piezoelektrischen Material auftreten, die zu kleinen Rissen, so genannte Mikrorisse, führen kann. Diese treten dort auf, wo die Reaktion zwischen PbO und Pd stattgefunden hat, also in dem Bereich, in dem die Beschichtung auf dem Elektrodenmaterial vor der Sinterung vorhanden war, beziehungsweise zwischen dem Elektrodenmaterial und dem piezoelektrischen Material.

Diese Mikrorisse können sich bei Betrieb des Vieschichtbauelements oder seiner Polarisation zu Entlastungsrissen oder Polungsrissen öffnen. Dadurch, dass die PbO-haltige Beschichtung auf dem Elektrodenmaterial den Bereich, in dem sich Mikrorisse bilden können, auf den Bereich, der direkt an die Innenelektroden des fertigen Vielschichtbauelements grenzt, beschränkt, können die Polungs- und/oder Entlastungsrisse ebenso auf diesen Bereich beschränkt werden. Der Bereich, der direkt an die Innenelektroden des fertigen Vielschichtbauelements grenzt, und auf den die Bildung der Mikrorisse beschränkt wird, wird auch dann erzeugt, wenn nur das Elektrodenmaterial PbO enthält, da auch dann nur in diesem Bereich PbPdO₂ gebildet wird. Damit wird die Bildung und der Verlauf von Polungs- und/oder Entlastungsrissen gezielt vorgegeben, so dass ein unkontrolliertes Wachstum und die Verzweigung dieser Risse quer zu den Innenelektroden vermindert oder verhindert werden kann.

In diesem Verfahren wird PbO, mit dem das Pd aus dem Elektrodenmaterial zu PbPdO₂ reagiert, homogen auf der Oberfläche des Elektrodenmaterials verteilt. Zusätzlich oder alternativ kann es auch zu dem Elektrodenmaterial gemischt werden, so dass es auch in dem Elektrodenmaterial homogen verteilt ist. Damit kann erreicht werden, dass die Zwischenphase aus PbPdO₂ gleichmäßig auf der Oberfläche des Elektrodenmaterials, zwischen dem Elektrodenmaterial und dem piezoelektrischen Material entsteht.

Damit wird bewirkt, dass gleichmäßig auf der Oberfläche des Elektrodenmaterials zwischen Elektrodenmaterial und piezoelektrischem Material eine Zwischenphase entsteht, die eine von dem piezoelektrischen Material unterschiedliche chemische Zusammensetzung und damit auch eine unterschiedliche mechanische Festigkeit und unterschiedliche elastische Eigenschaften aufweist. Auch können die thermischen Ausdehnungskoeffizienten dieser Zwischenphase und dem piezoelektrischen Material unterschiedlich sein. Damit wird die Bildung von Mikrorissen in genau diesem begrenzten Bereich der Zwischenphase begünstigt, wenn der Sintervorgang im Teilschritt D3) fortgesetzt und schließlich abgeschlossen wird. Um die gezielte Bildung von Mikrorissen in dem begrenzten Bereich sicher zu stellen, kann der Teilschritt D2) im Vergleich zu den Teilschritten D1) und D3) für einen längeren Zeitraum durchgeführt werden.

In dem fertigen Vielschichtbauelement liegt dann an zumindest einer Innenelektrode ein durch Mirkorisse geschwächter Bereich vor, in dem beispielsweise bei der Polarisation Polungsrisse entstehen können, die auf diesen Bereich beschränkt sind. Das Risswachstum kann somit gezielt parallel zu den Innenelektroden gesteuert werden.

Solche Polungsrisse können sich in einem dem Verfahrensschritt D) nachgeschalteten Verfahrensschritt E) bilden, in dem der gesinterte Stapel gepolt wird.

Dazu werden nach dem Sintern Außenelektroden an dem Stapel angebracht und die piezoelektrischen Schichten, die sich beim Sintern aus den piezoelektrischen Grünfolien gebildet haben, polarisiert.

Dabei wird beispielsweise zwischen benachbarten Innenelektroden eine Gleichspannung angelegt und der Stapel erwärmt. In so genannten inaktiven Zonen, in denen sich benachbarte Innenelektroden unterschiedlicher Polarität in Stapelrichtung nicht überlappen, dehnt sich das piezoelektrische Material gar nicht oder weniger aus als in den aktiven Zonen, in denen eine Überlappung auftritt. Durch die unterschiedliche Ausdehnung der piezoelektrischen Schichten in inaktiven und aktiven Zonen entstehen mechanische Spannungen, die während der Polarisation zu den Rissen führen können.

Damit können sich im Verfahrensschritt E) Polungsrisse bilden. Diese bilden sich in dem Bereich, in dem bereits Mikrorisse vorhanden sind. Die Polungsrisse können aus diesen Mirkorissen gebildet werden. Somit verlaufen die Polungsrisse parallel zu den Innenelektroden, in dem Bereich, in dem während der Sinterung die Zwischenphase aus PbPdO₂ vorhanden war.

Dieses Verfahren bewirkt also, dass die Bildung einer Zwischenphase aus PbPdO₂ effizienter gestaltet werden kann. Innenelektroden mit oder ohne PbO enthaltende Beschichtung können dabei eine Dicke von 3 bis 5 µm aufweisen, die Schichten aus piezoelektrischem Material eine Dicke von 30 bis 100 µm. Durch diesen Dickenunterschied kann bei dem Verfahren das gesamte PbO aus dem Elektrodenmaterial, wenn es zu diesem dazugemischt wurde, oder aus seiner Beschichtung zur Reaktion mit dem Pd und der gezielten Bildung der Zwischenphase zwischen Elektrodenmaterial und piezoelektrischem Material hinzugezogen werden.

Dabei kann die Bildung der Zwischenphase weniger abhängig von Temperaturprofil und/oder Sauerstoffpartialdruck während der Sinterung im Verfahrensschritt D) sein, da PbO im Überschuss zur Bildung der Zwischenphase vorhanden ist.

Die Kosten für dieses Verfahren können weiterhin reduziert werden, indem der Pd-Gehalt in dem Elektrodenmaterial reduziert wird. Die Zwischenphase wird dünner, wenn weniger Pd für die Reaktion mit PbO vorhanden ist, damit werden auch weniger auf den Bereich der Zwischenphase beschränkte Mikrorisse gebildet, was wiederum zu weniger Entlastungs- und/oder Polungsrissen führt.

Als Referenz wird weiterhin ein piezoelektrisches Vielschichtbauelement angegeben, das einen Stapel aus gesinterten piezoelektrischen Schichten und dazwischen angeordneten Innenelektroden aufweist, wobei auf der Oberfläche von zumindest einer Elektrode ein Bereich vorhanden ist, der Polungsrisse aufweist.

Dieser Bereich kann auf der gesamten Oberfläche der zumindest einen Innenelektrode vorhanden sein, so dass die Polungsrisse parallel zu der Innenelektrode verlaufen.

In diesem Bereich kann weiterhin ein im Vergleich zu den piezoelektrischen Schichten erhöhter Gehalt an PbO und/oder Spuren von PbPdO₂ vorhanden sein.

Als "piezoelektrische Schicht" wird ein Abschnitt des Stapels bezeichnet, der ein piezoelektrisches Material aufweist und in Stapelrichtung von zwei benachbarten Innenelektroden begrenzt wird. Eine piezoelektrische Schicht ist aus einer oder mehreren piezoelektrischen Lagen gebildet, die entlang der Stapelrichtung übereinander angeordnet sind. Beispielsweise kann eine piezoelektrische Lage aus einer piezoelektrischen Grünfolie hervorgehen. Eine piezoelektrische Schicht kann auch nur eine einzige piezoelektrische Lage aufweisen.

Die Innenelektroden können ein Material aufweisen, das Pd umfasst. Das Material kann aus einer Gruppe ausgewählt sein, die Mischungen und Legierungen aus Ag und Pd oder Cu und Pd umfasst.

Die piezoelektrischen Schichten können eine Keramik aufweisen, die Blei-Zirkon-Titanat umfasst.

Vorzugsweise sind auf zwei gegenüberliegenden Außenflächen des Bauelements Außenelektroden aufgebracht. Eine Außenelektrode umfasst beispielsweise eine auf dem Stapel eingebrannte Grundmetallisierung. Die Innenelektroden sind vorzugsweise entlang der Stapelrichtung des Bauelements abwechselnd mit den Außenelektroden verbunden. Dazu sind die Innenelektroden beispielsweise abwechselnd bis zu einer der Außenelektroden geführt und weisen zur zweiten Außenelektrode einen Abstand auf. Auf diese Weise sind die Innenelektroden einer Polarität über eine gemeinsame Außenelektrode elektrisch miteinander verbunden.

Die Polungsrisse, können weitgehend frei von Verzweigungen sein. Damit wird ein Vielschichtbauelement bereitgestellt, das eine hohe Zuverlässigkeit aufweist. Die Polungsrisse, die weitgehend frei von Verzweigungen sind und parallel zu der zumindest einen Innenelektrode verlaufen, können aufgrund ihrer räumlichen Anordnung nicht zu einem Kurzschluss des Bauelements führen, da sie nicht mehrere Innenelektroden verbrücken können.

Im Folgenden werden das angegebene Verfahren und das angegebene Vielschichtbauelement und ihre vorteilhaften Ausgestaltungen anhand von schematischen und nicht maßstabsgetreuen Figuren sowie anhand von Ausführungsbeispielen erläutert. Es zeigen:
- Figur 1: die schematische Seitenansicht des Vielschichtbauelements,
- Figur 2a: einen vergrößerten Ausschnitt der schematischen Seitenansicht des Vielschichtbauelements,
- Figur 2b: einen weiteren vergrößerten Ausschnitt der schematischen Seitenansicht des Vielschichtbauelements,
- Figur 3a: einen weiteren vergrößerten Ausschnitt der schematischen Seitenansicht des Vielschichtbauelements
- Figur 3b: einen weiteren vergrößerten Ausschnitt der schematischen Seitenansicht des Vielschichtbauelements.

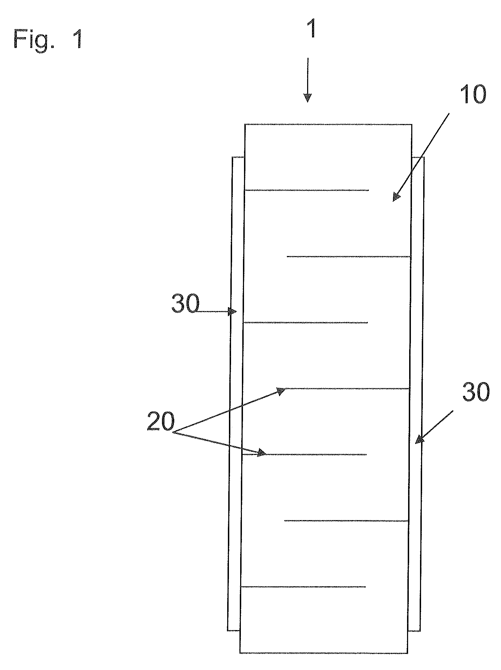

Figur 1 zeigt eine schematische Seitenansicht eines piezoelektrischen Vielschichtbauelements in Form eines Piezoaktors. Das Bauelement weist einen Stapel 1 aus übereinander angeordneten piezoelektrischen Schichten 10 und dazwischen liegenden Innenelektroden 20 auf. Die Innenelektroden 20 sind als Elektrodenschichten ausgebildet. Die piezoelektrischen Schichten 10 und die Innenelektroden 20 sind übereinander angeordnet.

Die piezoelektrischen Schichten 10 enthalten ein keramisches Material, zum Beispiel Blei-Zirkon-Titanat (PZT) oder eine bleifreie Keramik. Das Keramikmaterial kann auch Dotierstoffe enthalten. Die Innenelektroden 20 enthalten beispielsweise eine Mischung oder eine Legierung aus Ag und Pd oder Cu und Pd. Das Pd hat in dem Elektrodenmaterial einen Gewichtsanteil von bis zu 40%.

Zur Herstellung des Stapels 2 werden beispielsweise Grünfolien, die ein Keramikpulver, ein organisches Bindemittel und ein Lösungsmittel enthalten, durch Folienziehen oder Foliengießen hergestellt. Auf einige der Grünfolien wird zur Bildung der Innenelektroden 20 eine Elektrodenpaste mittels Siebdruck aufgebracht. Die Grünfolien werden entlang einer Längsrichtung übereinander gestapelt und verpresst. Aus dem Folienstapel werden die Vorprodukte der Bauelemente in der gewünschten Form herausgetrennt. Schließlich wird der Stapel aus piezoelektrischen Grünfolien und Elektrodenschichten gesintert.

Nach dem Sintern werden weiterhin Außenelektroden 30 angebracht, die auch in Figur 1 gezeigt sind.

In der hier gezeigten Ausführungsform sind die Außenelektroden 30 auf gegenüberliegenden Seitenflächen des Stapels 1 angeordnet und verlaufen streifenförmig entlang der Stapelrichtung. Die Außenelektroden 30 enthalten beispielsweise Ag oder Cu und können als Metallpaste auf den Stapel 2 aufgebracht und eingebrannt werden.

Die Innenelektroden 20 sind entlang der Stapelrichtung abwechselnd bis zu einer der Außenelektroden 30 geführt und von der zweiten Außenelektrode 30 beabstandet. Auf diese Weise sind die Außenelektroden 30 entlang der Stapelrichtung abwechselnd mit den Innenelektroden 20 elektrisch verbunden. Zur Herstellung des elektrischen Anschlusses kann auf die Außenelektroden 30 ein Anschlusselement (hier nicht gezeigt), z. B. durch Löten, aufgebracht werden

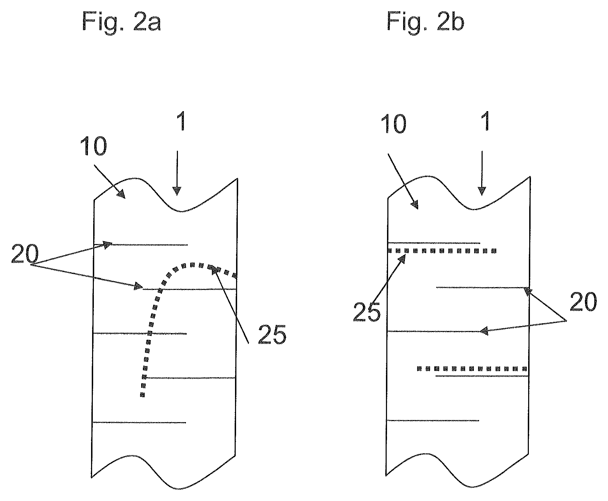

Figur 2a zeigt einen vergrößerten Ausschnitt der schematischen Seitenansicht des Vielschichtbauelements.

Das Bauelement dehnt sich beim Anlegen einer Spannung zwischen die Außenelektroden 30 in Längsrichtung aus. In einer so genannten aktiven Zone, in der sich in Stapelrichtung benachbarte Innenelektroden 20 überlappen, entsteht beim Anlegen einer Spannung an die Außenelektroden 30 ein elektrisches Feld, sodass sich die piezoelektrischen Schichten 10 in Längsrichtung ausdehnen. In inaktiven Zonen in denen sich benachbarte Elektrodenschichten 20 nicht überlappen, dehnt sich der Piezoaktor nur geringfügig aus.

Aufgrund der unterschiedlichen Ausdehnung des Bauelements in den aktiven und inaktiven Zonen treten mechanische Spannungen im Stapel 1 auf. Derartige Spannungen können zu Polungs- und/oder Entlastungsrissen 25 im Stapel 1 führen.

Die Figur 2a zeigt einen Ausschnitt aus einem Stapel 1 aus piezoelektrischen Schichten 10 und Innenelektroden 20, bei dem ein Riss 25 im Stapel 1 entstanden ist. Der Riss 25 verläuft innerhalb der inaktiven Zone parallel zu den Innenelektroden 20, knickt beim Übergang in die aktive Zone ab und verläuft in der aktiven Zone durch benachbarte Innenelektroden 20 unterschiedlicher Polarität hindurch. Dies kann zu einem Kurzschluss der Innenelektroden 20 führen.

Figur 2b zeigt einen Ausschnitt aus einem Stapel 1 aus piezoelektrischen Schichten 10 und Innenelektroden 20, in dem ebenfalls ein Riss 25 entstanden ist. Hier verläuft der Riss 25 parallel zu den Innenelektroden 20. Bei einem derartigen Verlauf von Rissen 25 ist die Gefahr von Kurzschlüssen verringert.

Um einen derartigen Verlauf von Rissen 25 zu begünstigen, wird bei der Herstellung des Vielschichtbauelements auf zumindest eine Schicht aus Elektrodenmaterial mit einer Beschichtung aus PbO versehen. Das PbO kann in Form von PbO-Pulver, Pb₃O₄ oder einem anderen PbO-haltigen Material aufgebracht werden. Flüssige Formen von Pb-haltigen chemischen Verbindungen sind ebenso möglich. Die Korngröße des PbO kann einen Medianwert d₅₀ (die Verteilung der Partikelgröße) von 0,1 µm bis 2 µm, bevorzugt 0,3 µm bis 1,5 µm aufweisen.

Es kann auch zusätzlich oder alternativ PbO zu dem Elektrodenmaterial gemischt werden. Dann ist der Gehalt von PbO bezogen auf die Summe von PbO und den übrigen Metallen des Elektrodenmaterials bis 100 Gew%, bevorzugt bis zu 50 Gew%.

Es kann eine Schicht aus Elektrodenmaterial mit der Beschichtung versehen werden oder PbO enthalten, vorzugsweise können alle Schichten eine Beschichtung aufweisen oder PbO enthalten.

Während des Sinterns bildet sich dann eine Zwischenphase, die PbPdO₂ enthält und die auf den Bereich, in dem das PbO vorhanden war, räumlich beschränkt ist. Aufgrund des unterschiedlichen Volumens und des unterschiedlichen Ausdehnungsverhaltens dieser Zwischenphase und der anliegenden piezoelektrischen Schicht entstehen in dem Bereich der Zwischenphase Mikrorisse. Nach Abschluss des Sinterns, wenn sich das PbPdO₂ wieder zurückgebildet hat, bleibt der durch Mikrorisse geschwächte Bereich zwischen Innenelektrode und piezoelektrischer Schicht zurück. Aus diesen Mikrorissen können sich dann Entlastungs- und/oder Polungsrisse bilden, die ebenfalls nur räumlich beschränkt auftreten. Eine Verzweigung dieser Risse wird damit vermindert oder verhindert.

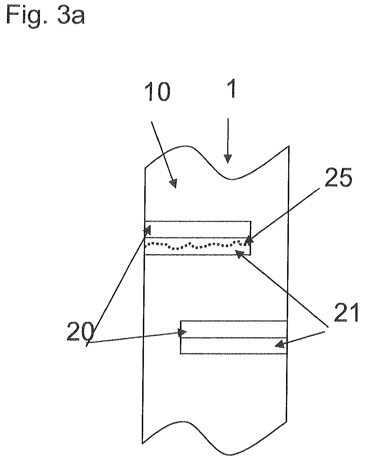

Figur 3a zeigt einen weiteren Ausschnitt aus einer schematischen Seitenansicht des Vielschichtbauelements. Auch hier ist ein Riss 25 entlang einer Innenelektrode 20 ausgebildet. Zusätzlich ist der Bereich 21, in dem der Riss räumlich eingeschränkt ist gezeigt.

Dieser Bereich 21 befindet sich zwischen der Innenelektrode 20 und der piezoelektrischen Schicht 10, und zwar dort, wo während des Herstellungsverfahrens die PbO enthaltende Beschichtung auf der Elektrodenpaste angeordnet war. In diesem Bereich hat das PbO mit dem Pd aus dem Elektrodenmaterial zu PbPdO₂ reagiert und somit die Zwischenphase gebildet. In der Zwischenphase haben sich wie oben beschrieben Mikrorisse bilden können, die sich während der Polarisation zu Rissen geöffnet haben. Der Riss kann sich nur in diesem Bereich 21 fortpflanzen, so dass er keine Verzweigungen ausbildet.

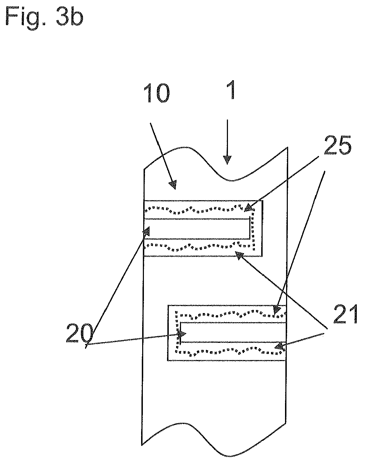

Figur 3b zeigt einen Ausschnitt aus einer schematischen Seitenansicht des Vielschichtbauelements analog zu Figur 3a. Hier verlaufen die Risse 25 um die Innenelektroden 10 herum. Eine solche Verteilung kann vor allem dann auftreten, wenn das PbO mit dem Elektrodenmaterial gemischt wurde, so dass der Bereich, in dem PbPdO₂ entsteht, gleichmäßig um die Elektrodenschicht herum auftritt.

Ein derart hergestelltes Vielschichtbauelement kann reines Blei-Zirkon-Tiatanat (PZT) oder ein mit Dotierstoffen modifiziertes PZT enthalten.

Ein Beispiel für ein Vielschichtbauelement weist als PZT-Keramik der piezoelektrischen Schicht 10 ((Pb₁₋ₓ₊ₐ, Ndₓ)((Zr_{1-z}, Ti_{z})_{1-y}, Ni_{y})O₃auf. Dabei können x = 0,0001 bis 0,06, a = 0 bis 0,05, z = 0,35 bis 0,60 und y = 0,0001 bis 0,06 sein. Als Beschichtung für die Elektrodenschicht wird ein PbO-Pulver verwendet, das eine Korngröße von 1µm aufweist. Die Innenelektroden enthalten Cu und Pd und einen Gewichtsanteil von PbO in dem Elektrodenmaterial von 10% bis 50%. Alle Elektrodenschichten werden für das Herstellungsverfahren mit PbO bedruckt.

### Bezugszeichenliste

- 1: Stapel
- 10: piezoelektrische Schicht
- 20: Innenelektrode
- 21: Bereich
- 25: Riss
- 30: Außenelektroden

## Patentansprüche

1. Verfahren zur Herstellung eines piezoelektrischen Vielschichtbauelements umfassend die Schritte:
A) Bereitstellen von piezoelektrischen Grünfolien enthaltend ein piezoelektrisches Material,
B) Bereitstellen eines Elektrodenmaterials enthaltend Pd,
C) Abwechselndes Anordnen von Grünfolien und Schichten aus Elektrodenmaterial zur Bildung eines Stapels (1),
D) Sintern des Stapels (1),
wobei im Verfahrensschritt C) zumindest eine Schicht aus Elektrodenmaterial mit einer Beschichtung, die PbO enthält, versehen wird und/oder im Verfahrensschritt B) dem Elektrodenmaterial PbO beigemischt wird,
**dadurch gekennzeichnet, dass**
der Verfahrensschritt D) die Teilschritte
D1) Sintern bei einer Temperatur von bis zu 400°C,
D2) Sintern bei einer Temperatur, die in einem Bereich von 400°C bis 700°C liegt,
D3) Sintern bei einer Temperatur von über 700°C umfasst, wobei sich im Teilschritt D2) zwischen dem Elektrodenmaterial und dem piezoelektrischen Material eine Zwischenphase enthaltend PbPdO₂ bildet.

2. Verfahren nach dem vorhergehenden Anspruch, wobei das PbPdO₂ aus dem Pd, das im Elektrodenmaterial enthalten ist, und dem PbO, das in der Beschichtung und/oder in dem Elektrodenmaterial enthalten ist, gebildet wird.

3. Verfahren nach einem der Ansprüche 1 oder 2, wobei das PbPdO₂ ein größeres Volumen aufweist als PbO und als das piezoelektrische Material.

4. Verfahren nach einem der Ansprüche 1 bis 3, wobei sich zwischen dem Elektrodenmaterial und dem piezoelektrischen Material Mikrorisse bilden können.

5. Verfahren nach einem der Ansprüche 1 bis 4, wobei das PbPdO₂ im Teilschritt D3) zumindest teilweise in Pd und PbO zersetzt wird.

6. Verfahren nach einem der vorhergehenden Ansprüche, wobei im Verfahrensschritt C) die Beschichtung mittels Siebdruck auf das Elektrodenmaterial aufgebracht wird.

7. Verfahren nach einem der vorhergehenden Ansprüche, das einen dem Verfahrensschritt D) nachfolgenden Verfahrensschritt E) aufweist, in dem der gesinterte Stapel gepolt wird.

8. Verfahren nach dem vorhergehenden Anspruch, wobei sich im Verfahrensschritt E) Polungsrisse (25) bilden können.

9. Verfahrensschritt nach dem vorhergehenden Anspruch, wobei die Polungsrisse aus den Mikrorissen gebildet werden.

## Claims

1. Method for producing a piezoelectric multilayer component, comprising the steps:
A) providing piezoelectric green films containing a piezoelectric material,
B) providing an electrode material containing Pd,
C) alternately arranging green films and layers of electrode material in order to form a stack (1),
D) sintering the stack (1),
wherein at least one layer of electrode material is provided with a coating which contains PbO in method step C) and/or PbO is mixed with the electrode material in method step B), **characterized in that** method step D) comprises the substeps
D1) sintering at a temperature of up to 400°C,
D2) sintering at a temperature which lies in a range of from 400°C to 700°C,
D3) sintering at a temperature of more than 700°C, an intermediate phase containing PbPdO₂ being formed between the electrode material and the piezoelectric material in substep D2).

2. Method according to the preceding claim, wherein the PbPdO₂ is formed from the Pd which is contained in the electrode material and from the PbO which is contained in the coating and/or in the electrode material.

3. Method according to one of Claims 1 and 2, wherein the PbPdO₂ has a larger volume than PbO and than the piezoelectric material.

4. Method according to one of Claims 1 to 3, wherein microcracks can form between the electrode material and the piezoelectric material.

5. Method according to one of Claims 1 to 4, wherein the PbPdO₂ is at least partially decomposed into Pd and PbO in substep D3).

6. Method according to one of the preceding claims, wherein the coating is applied onto the electrode material by means of screen printing in method step C).

7. Method according to one of the preceding claims, which comprises a method step E) which follows method step D) and in which the sintered stack is poled.

8. Method according to the preceding claim, wherein poling cracks (25) can be formed in method step E).

9. Method step according to the preceding claim, wherein the poling cracks are formed from the microcracks.

## Revendications

1. Procédé de fabrication d'un élément multicouche piézo-électrique comprenant les étapes suivantes :
A) fourniture de feuilles brutes piézo-électriques contenant un matériau piézo-électrique,
B) fourniture d'un matériau d'électrode contenant du Pd,
C) disposition en alternance de feuilles brutes et de couches constituées de matériau d'électrode pour former un empilement (1),
D) frittage de l'empilement (1),
au moins une couche constituée d'un matériau d'électrode étant munie à l'étape de procédé C) d'un revêtement contenant du PbO et/ou du PbO étant mélangé au matériau d'électrode à l'étape de procédé B),
**caractérisé en ce que**
l'étape de procédé D) comprend les étapes partielles
D1) de frittage à une température allant jusqu'à 400° C,
D2) de frittage à une température située dans une plage de 400° C à 700° C,
D3) de frittage à une température supérieure à 700° C, une phase intermédiaire contenant du PbPdO₂ se formant à l'étape partielle D2) entre le matériau d'électrode et le matériau piézo-électrique.

2. Procédé selon la revendication précédente, dans lequel le PbPdO₂ est formé à partir du Pd, contenu dans le matériau d'électrode, et du PbO, contenu dans le revêtement et/ou dans le matériau d'électrode.

3. Procédé selon l'une quelconque des revendications 1 ou 2, dans lequel le PbPdO₂ présente un plus grand volume que le PbO et que le matériau piézo-électrique.

4. Procédé selon l'une quelconque des revendications 1 à 3, dans lequel des microfissures peuvent se former entre le matériau d'électrode et le matériau piézo-électrique.

5. Procédé selon l'une quelconque des revendications 1 à 4, dans lequel le PbPdO₂ est au moins en partie décomposé en Pd et en PbO à l'étape partielle D3). Une

6. Procédé selon l'une quelconque des revendications précédentes, dans lequel, à l'étape de procédé C), le revêtement est appliqué par sérigraphie sur le matériau d'électrode.

7. Procédé selon l'une quelconque des revendications précédentes, présentant une étape de procédé E) suivant l'étape de procédé D), dans laquelle l'empilement fritté est polarisé.

8. Procédé selon l'une quelconque des revendications précédentes, dans lequel, à l'étape de procédé E), des fissures de polarisation (25) peuvent se former.

9. Etape de procédé selon l'une quelconque des revendications précédentes, dans laquelle les fissures de polarisation sont formées à partir des microfissures.
